# EUROPEAN PATENT APPLICATION

(11) **EP 3 561 144 A1**
(43) Date of publication of application: **30.10.2019**
(21) Application number: 18460025.2
(22) Date of filing: 27.04.2018
(51) Int. Cl.: C23C 10/08, C23C 14/16, C23C 16/08, C23C 30/00

(54) **METHOD OF DEPOSITING A ZINC LAYER ON THE SURFACE OF STEEL ELEMENTS AND A UNIT FOR DEPOSITION OF A ZINK LAYER ON THE SURFACE OF STEEL ELEMENTS**

(71) Applicant: Remix spolka akcyjna, 66-200 Swiebodzin (PL)
(72) Inventor: BIENIASZ, Krzysztof, 65-153 Zielona Góra (PL); PRACZYK, Marek, 66-300 Miedzyrzecz (PL); SIPA, Jacek, 66-200 Swiebodzin (PL); BAK, Lukasz, 66-200 Swiebodzin (PL)
(74) Representative: Luczak, Jerzy

(57) **Abstract**

The subject of the invention is a method of depositing a zinc layer on the surface of steel elements and a unit for deposition of a zinc layer on the surface of steel elements, used for industrial coating of steel elements with increased strength requirements

The method is characterized by the charge for zinc deposition being placed in the central retort and the zinc powder with inert additives and activator is placed in the main retort, whereas both retorts are placed basically on the same axis, moreover the zinc powder in the form of a powder mixture is heated to a temperature exceeding 330°C, in which the activator decomposes into ammonia, chlorine and hydrogen, and afterwards, as a result of the flow of active gases forced by the fan, generating zinc chloride through the internal retort it covers the surface of the poured over elements by the contact of the steel charge with zinc and zinc chloride in gas form.

The unit is characterized by it being formed by a body, in which heating elements are placed and a chamber which forms the main retort for the pouring of the zinc powder and a smaller central retort, advantageously placed in the same axis with the main retort, used to contain the charge, whereas the central retort is placed on an axis connected with the drive mechanism, which causes an oscillatory movement around the lengthwise axis, and a fan for forcing the flow of the reaction atmosphere through the central retort, moreover the central retort cylinder has on both sides a perforated closure, ensuring the flow of reaction atmosphere and powder suspension.

## Description

The subject of the invention is a method of depositing a zinc layer on the surface of steel elements and a unit for deposition of a zinc layer on the surface of steel elements, used for industrial coating of steel elements with increased strength requirements

Zinc coatings are the most common anti-corrosion protection of iron and steel. They exhibit ease of depositing, varied methods of coating the surface, and primarily significant corrosion resistance. Natural resistance of zinc to atmospheric corrosion is explained by the creation of poorly soluble oxide and hydroxide layers with the same thermal expansion coefficient as the base metal, thus preventing flaking with temperature variations. This resistance is a property which is also exhibited by zinc coatings, and their durability is directly proportional to their thickness.

There are multiple methods of depositing of zinc coatings: hot galvanizing, electrogalvanizing, hot spraying and diffusion method. Zinc coatings deposited on steel surfaces using zinc powder diffusion methods demonstrate multiple utility advantages. This process is included in the category of thermo-chemical processes and is most commonly known as "Sherardizing", from the name of its inventor. In 1900 a British scientist and metallurgy engineer Sherard Cowper-Coles, while conducting experiments with annealing of steel using zinc powder as an inert filler has observed the process of diffusion of zinc atoms within the steel substrate. After two years of research and development he has established a technology of zinc coating of steel elements by thermal diffusion, and the invented method was patented with the US Patent Office in 1902 [1]. As a result of the process a layer of Fe-Zn inter-metallic phases is obtained at the steel surface, which demonstrates higher corrosion resistance than pure zinc. These coatings also demonstrate high abrasion resistance.

The thermal diffusion zinc coating method has changed over years, mainly due to the selection of powder mixture ingredients, which should always contain: coat material (zinc), inert filler (which prevents the melting and sintering of the zinc powder and sticking to the surface of the product), process activator (which generates active gas medium). The thermal and mechanical treatment process using the contact-gas method consists of generating in the saturating mixture of active gases, which by interacting with the processes surface result in the release of atoms of a specific element, e.g. zinc, which may diffuse into the material. The chemical composition of the gas mixture depends on the composition of the powder mixture, type of used activator and process temperature.

The "sherardization" technology became very popular in the United States before the introduction of other steel coating techniques in the 1930s. In the first quarter of the 20^{th} century there were at least 25 enterprises in the US which have zinc coated steel using thermal diffusion method. A series of technological devices which improve that process were patented during that time. Initially the process was conducted in hermetically sealed containers, in which the steel details were placed and the powder mixture was poured over. The container was then heated to the process temperature, which enables the diffusion of zinc atoms within the steel substrate. After a specific time the container was slowly cooled to ambient temperature. In order to improve the process - the accuracy of coating the surface with a protective coat, the duration of processing, improvement of production - a series of works were conducted to develop new devices.

The solutions concerned the manner of heating the furnace and the homogenization of process parameters within the retort space. A solution with a retort which rotates around its own axis in the furnace heating space during the process was very well received. It resulted in significant improvement of accuracy of coating of the elements with a zinc coat. Multiple solutions were patented [2-8] with various methods of rotating the retort in the furnace, of heating the retort and increasing the productivity due to the placement of multiple retorts within the furnace space. The rotating retort process method is still used today. After the 2nd World War many design solutions for thermal diffusion coating were not patented. The most interesting seems the solution of the Distek company [9] with a tunnel furnace, in which the retorts move in a sequence through the heating space, while simultaneously rotating around their axes through the use of a special chain conveyor. The proposed solution shortens the production cycle. Two Chinese solutions are also known (one as an application) with a rotating retort, which improve the production process and operational safety [15, 16].

At the end of 20^{th} century most scientific papers and patent applications concerned the composition of the powder mixture - type of filler, process activator and additives of other elements - in order to improve the properties of the protection coating, its corrosion resistance (in particular in increased temperatures) and abrasion resistance. Processes occurring during the deposition of the coat, its phase composition and formation kinetics were also tested [26, 27]. Compared to the coatings obtained by the dip method, the standard thermal diffusion coat is composed only of Fe-Zn phases - a thin gamma layer rich in iron near the steel base and external delta phase with a smaller contents of iron [17, 19]. A layer of pure zinc on the surface is not created. This structure results in the thermal diffusion coating deposited on the surface being hard (the currently obtained coatings have a hardness level around 41 HRC) and abrasion resistant. Tests have also demonstrated very good corrosion resistance of coatings not only in lower temperatures, but also in a temperature of 400°C.

The cracks caused by high temperature do not result in overly acceleration corrosion phenomena. The corrosion potential of zinc coatings is lower than the corrosion potential of steel, and if the surface layer is damaged the steel will be provided with anode protection by the zinc coat [18].
Addition of some elements significantly impacts the composition of the coat and its properties. Already in 1924 in the United States a composition of mixture containing an addition of iron in an amount of 6-10% was patented, which impacts the increase of the coating strength [14]. This composition of the mixture also allows the conducting of coating deposition process in higher temperatures, even above the zinc melting temperature, without the powder mixture exhibiting a tendency for clumping.
Advantageous effects of introducing an addition of aluminium to the zinc bath in the dip galvanization process, intended to increase corrosion resistance, have inclined researchers to introduce this element to powder mixtures in order to improve the durability of coatings in increased temperatures and to prevent the occurrence of cracks. The conducted scientific research [20, 21, 22] have confirmed the advantageous impact of aluminium on the corrosion resistance of obtained coatings. In 2007 the Greenkote company has patented the composition of zinc mixtures with an addition of aluminium up to 50% of the volume of the mixture and an addition of magnesium and silicon [11].
The results of tests of coatings with an addition of Al presented in the patent description have confirmed the positive impact of this element on corrosion resistance.
The scientific research has also confirmed the advantageous impact of silicon on the properties of thermal diffusion zinc coatings [22]. The impact of this element increases coat hardness and improves corrosion resistance. The compositions of powder mixtures containing additives of various metal oxides (titanium, cobalt, chromium) with an impact on the colouring of the coating surface and on the coating's corrosion resistance were patented [10].
On the global market the technology of the Bodycote company is also known, based on controlling the oxygen contents in the reaction atmosphere or the application within the retort space of another process gas that does not contain oxygen. The technology is protected by patent law [12], the description does not provide the results of tests over coatings obtained in this manner.
The most commonly used and patented solution [13] is the technology of Distek Ltd. Company, based on a special composition of zinc powder and method of conducting the process. The composition of the mixture is not specified in the available patent description, nor in publications [23, 24]. An important advantage of the technology is simplified preparation of the surface before zinc deposition. This has been the only technology offered so far on the Polish market, due to the local representation of the company.
In the last years studies have been conducted on thermal diffusion zinc coatings and zinc-aluminium coatings obtained in a fluidized bed [21, 25]. The flow of reaction atmosphere has an advantageous impact on the thermal diffusion process and on the quality of obtained coatings.
Conducting the process in a fluidized bed intensifies the diffusion process (thicker coat), the zinc-aluminium coatings are less porous and brittle, while simultaneously retaining significant hardness compared to other known process methods. The corrosion resistance of the elements zinc coated in such a manner is also increased. So far thermal diffusion coating in a fluidized bed remains at the stage of scientific research.
The development of the thermal diffusion zinc coating technology has enabled the obtaining of very competitive zinc coatings compared to safeguards obtained with the use of other methods. The main advantages of the technology include:
□ obtaining a durable coat which is well bonded with the substrate,
□ obtaining very high corrosion resistance (even up to 1500 h in a salt chamber),
□ obtaining a hard surface ensuring high abrasion resistance,
□ obtaining a reproducible protective coat with a thickness of 20-120 µm with a highly uniform structure, evenly spread over the entire surface,
□ lack of zinc accretions on the edges, which is especially important in case of threaded connections,
□ obtaining excellent adhesion of the surface for the applied paint and vulcanization coats,
□ maintaining the mechanical properties of zinc coated parts due to a relatively low process temperature. This allows the coating of special parts, such as bolts and some springs, due to a relatively low process temperature,
□ possibility of regenerating the separated remains of post-treatment powder,
□ no toxic process waste, which results in the technology being environmentally friendly,
□ obtaining a durable layer - without flaking and micro-cracks,
□ possibility of applying zinc coats with various colours,
□ reduction of personnel costs,
□ low operational costs of the process, mainly due to the low consumption of electrical power and lack of process waste,
□ zinc coating of products with a complex shape,
□ excellent painting substrate due to a surface with a high expansion area.

The technology limitations include:
□ process durability,
□ no possibility of zinc coating large elements with complicated shapes,
□ lower efficiency compared to standard methods,
□ grey, matte surface - decorative issues.

The use of the solution presented in the invention will enable increasing the area of application. Recirculation of reaction atmosphere will enable obtaining coatings with a similar/same structure as the currently tested thermal diffusion coatings obtained in a fluidized bed. The use of atmosphere recirculation significantly simplifies the realisation process.
For powder mixtures components such as iron, aluminium, chromium and silicon may be used, but in a form which has not yet been used. This results in a significant decrease of the powder mixtures production costs.

The goal of the invention is to develop and implement of a new thermal diffusion zinc coating technology with the possibility of recirculating reaction atmosphere, which will allow the obtaining of protective coats with better properties than the ones obtained when using currently known zinc coating methods. The use of additional, new components in zinc powder mixtures will ensure obtaining of corrosion protection coats with better corrosion resistance. This will enable the increase of abrasion resistance of the coats, and the temperature and character of the process will enable maintaining the required strength properties of the zinc coated elements. The proposed technology, the possibility of controlling of parameters and process repeatability will ensure the obtaining of coats with a required thickness, also very thin ones. It should be noted that the thermal diffusion coats are characterised by an growth of protective phases within the material subject to treatment, which allows the use of this technology in case of mated elements, where dimensional tolerances are very important. Recirculation of reaction atmosphere also guarantees the sustainability of the process and lower generation of waste when compared to the currently used thermal diffusion zinc coating techniques.

The aforementioned factors mean that the new technology will be used in particular in case of metal plating of important structural elements:
- working in a strongly corrosive environment, when standard zinc coats do not guarantee long term protection,
- working under sliding friction conditions,
- subject to significant mechanical stresses, where the material strength must be maintained at a specified level,
- mated element with specific dimensional tolerance (sleeve - pin, bolt - nut). The aforementioned technology will enable the construction of improved products used by various branches of industry.

The goal of the invention is to construct and test the prototype of a process device, which will enable performing a new process of applying zinc coats with much better utility parameters.

In reference to the above the subject of the invention is the technology of thermal diffusion zinc coating with recirculation of reaction atmosphere, which will ensure the obtaining of protective coating with the utility properties which are not guaranteed by the methods used today. The new technology will be used mainly in the manufacturing of steel structural elements for special purposes. An example of such elements are HV type high strength bolts, frequently used during the installation of zinc-coated steel structures. Currently the manufacturers use hot galvanizing method in order to protect such bolts against corrosion. This technique does not guarantee maintaining the material's strength properties. The high strength bolts are manufactured using steel with a hardening capacity which ensures a structure with a contents of approx. 90% of martensite in the core of the threaded part before tempering.
The tempering temperature of class 8.8 and 10.9 bolts amounts to 425°C, for class 12.9 bolts this temperature amounts to 380°C. These material treatment parameter requirements mean that hot dip galvanizing in the temperature of 455°C, and frequently even higher will result in a significant tempering of the bolt's material and reduction of tensile strength below the required values. The controlling and maintaining of stable process parameters also leads to many difficulties, which leads to obtaining of coats with varying thicknesses and problems with the mating of a bolt with a nut. An example of elements operating in a strongly corrosive environment and in conditions which result in the risk of coat abrasion are the assembly part of drill strings. The main element of the drill string is formed by drilling rods, also called drilling fluid pipes.
They fulfil a series of important tasks in the borehole, in combination with the remaining elements of the drill string, such as transferring the torque from the drilling device to the mining device, exert axial pressure on the drilling tool, supply drilling fluid to the borehole in order to transport the borings to the surface, control the axis of the drilled borehole according to the previously made design assumptions. Drilling rods are operating in the borehole under difficult conditions, generate extreme longitudinal, transverse and torsional loads on their surface, are also exposed to abrasive action of the rocks and corrosive impact of the drilling fluid. These operational conditions impose significant requirements for the material from which the rods are manufactured and their threaded connections.
Currently expensive chromium-nickel-molybdenum steels are used for manufacturing, which ensure not only high resistance of the rods, but also corrosion and abrasion resistance.
An alternative solution would be to use cheaper high strength materials, where the rod's abrasion and corrosion resistance would ensure a durable, state of the art zinc coating obtained using the thermal diffusion method. Currently the length of pipe elements is not a problem for the use of this method of deposition of protective coatings, since on the Eastern market the case of implementing a thermal diffusion zinc coating process line for 12 meters long pipes is known.
The proposed technology of depositing zinc coatings will certainly find use in many other areas of manufacturing, where the use of current methods of zinc coating is insufficient or impossible due to high requirements for the coating properties.

The goal of the invention is to establish a thermal diffusion zinc coating technology with recirculation of reaction atmosphere in order to obtain the best properties, meeting high requirements established for the elements subject to the treatment, with recirculation of reaction atmosphere - for the depositing of coatings with high corrosion and abrasion resistance.

The most commonly used zinc coating technologies currently used industrially do not ensure the deposition of protective coating with high abrasion resistance, long-term corrosion protection, repeatability of the coating structure and the possibility of controlling its thickness. In case of responsible structural elements these aspects are very important and in many cases the use of known galvanization techniques provides insufficient or even impossible effects, if the project will contribute to the decrease of strength (through tempering) of the material subjected to surface treatment.
When using the dip galvanizing method a significant role is played by a relatively long time of immersing the product in hot bath of liquid zinc, which may negatively impact the strength properties of the product. A coat of significant thickness is created in such conditions. The complexity of coating growth processes and the impact of multiple process parameters results in the fact that controlling the coating thickness is practically impossible. The manner of placing the object in the bath and removing it from the bath does not guarantee uniformity of coating thickness over the entire product. This presents a significant problem in case of mating elements with specific dimensional tolerances. The protective coatings obtained by dip galvanization are characterised by a rather thick top layer of pure zinc, which is soft and less corrosion resistant than the zinc-iron (Fe-Zn) layers below.
The electrolytic zinc coating method ensures good distribution of zinc over the entire steel substrate area, good plasticity due to the pillar-shaped construction of the coating. Due to low thicknesses of coats obtained by electrolytic method (usually up to 15 0281 µm) their significant corrosion resistance in the initial stage of operation rapidly decreases in a short time, which predisposes the elements zinc coated using this method for operation in only slightly corrosive environments.
It should be also noted that electrolytic zinc coating is an uneconomical process, highly polluting to the national environment and highly harmful to the employee's health.
Spray zinc coating allows the coating of larger structures with a protective coating. Does not result in thermal loads on the processed item, which prevents any deformation. It should be noted that obtaining an appropriate quality of the spray-on coating requires thorough cleaning of the covered surface. The drawback of this method is also the fact that cavities and hard to reach places such as bends cannot be coated. The thickness of the coating depends on the accuracy of application and is not uniform over the entire surface of the processed product.
As the studies show, coatings obtained by hot spraying are characterised by significant speed of corrosion.
The characteristic features of standard zinc coating processes do not allow the treatment when particularly important elements have to be covered by a zinc coat. Significant risk of the loss of strength properties of the material and not ensuring an appropriate coating structure, corrosion and abrasion resistance result in the need to find new technological coating solutions, which will allow the use of cheaper high strength carbon steels with appropriate surface protection instead of expensive high strength corrosion resistant steels, retaining appropriate strength properties of the material after treatment. The new technology would also enable obtaining coats with much better properties for the current special purpose assortment, e.g. high strength bolts, which will impact the life of the structure.
A new technology for the deposition of thermal diffusion zinc coats on external surfaces of important structural elements, which require high resistance to loads and significant corrosion and abrasion resistance was established according to the invention. The thermal diffusion zinc coating technology with the use of zinc powder has been known since the beginnings of the 20^{th} century. The proposed solution assumes that by the introduction of reaction atmosphere recirculation ensures its uniform composition, which will impact the intensification of saturation process and the effectiveness of the use of active ingredients. Adding into the powder mixture of additives which will increase the corrosion resistance of the protective coat while decreasing its brittleness is also a novelty. Adding modifying additives to the mixtures, in the form of waste products from other processes (hard zinc, silicon carbide, chromium carbide) will decrease the mixtures' manufacturing costs.

The essence of the invention, which is a method for depositing a layer of zinc on the surface of steel elements by keeping the elements in zinc powder, containing inert additives, advantageously zinc chloride or ammonium chloride as gas activators which generate the reaction atmosphere and heating over a time of (1-1.5) hours to a temperature of (370-490)°C, afterwards annealing in this temperature within a time of up to 4 hours, afterwards cooling together with the furnace to the ambient temperature, consists of the charge for the deposition of a zinc layer is placed in a central retort, and the zinc powder with inert additives and activator is placed in the main retort, whereas both retorts are placed basically on the same axis, moreover the zinc powder in the form of a powder mixture is heated to a temperature exceeding 330°C, in which the activator decomposes into ammonia, chlorine and hydrogen, and afterwards, as a result of the flow of active gases forced by a fan, generating zinc chloride through an internal retort it covers the surface of the poured over elements by the contact of the steel charge with zinc and zinc chloride in gas form.

This method is performed in the unit for the deposition of a zinc layer on the surface of steel elements, according to the invention, having a heating element for the heating and maintaining of the charge temperature, the essence of which consists of it being formed by a body, in which heating elements are placed and a chamber which forms the main retort for the pouring of the zinc powder and a smaller central retort, advantageously placed in the same axis with the main retort, used to contain the charge, whereas the central retort is placed on an axis connected with the drive mechanism, which causes an oscillatory movement around the lengthwise axis, and a fan for forcing the flow of the reaction atmosphere through the central retort, moreover the central retort cylinder has on both sides a perforated closure, ensuring the flow of reaction atmosphere and powder suspension.

It is advantageous when the central retort moves in an oscillatory manner within the range of 330° compared to its lengthwise axis.

The subject of the invention, in an example implementation, which is not limiting, was shown using an example, whereas in order to better illustrate the invention a unit for the deposition of a zinc layer on the surface of steel elements was presented.

The unit is formed by the body 1, in which the heating elements 2 are placed and a chamber, forming the main retort 3 for the pouring of zinc powder and a smaller central retort 4 placed advantageously in the same axis with the main retort 3, used to contain the charge. The central retort 4 is placed on an axis connected with the drive mechanism 5, which causes an oscillatory movement around the lengthwise axis, and a fan 6 for forcing the flow of the reaction atmosphere through the central retort 4, moreover the central retort cylinder 4 has on both sides a perforated closure 5, ensuring the flow of reaction atmosphere and powder suspension.

The central retort 4 moves in an oscillatory manner within the range of 330° compared to its lengthwise axis. As a result of the oscillatory movement of the retort 4 the charge moves around and the further surfaces of the charge details are uncovered, coming into contact with the reaction atmosphere.

The unit is equipped with measurement devices 7 for the measurement of temperature within the heating space (heating elements) and the working space (retort) of the device.

The main retort 3 containing inert additives, advantageously zinc chloride or ammonium chloride as gas activators which generate the reaction atmosphere, which are heated over a time of (1-1.5) hours to a temperature of (370-490)°C, afterwards annealing in this temperature within a time of up to 4 hours, afterwards cooling together with the furnace to the ambient temperature. The charge for zinc deposition is placed in the central retort 4 and the zinc powder with inert additives and activator is placed in the main retort 3, whereas both retorts 3 and 4 are placed basically on the same axis, moreover the zinc powder in the form of a powder mixture is heated to a temperature exceeding 330°C, in which the activator decomposes into ammonia, chlorine and hydrogen, and afterwards, as a result of the flow of active gases forced by the fan 6, generating zinc chloride through the internal retort 4 it covers the surface of the poured over elements by the contact of the steel charge with zinc and zinc chloride in gas form.

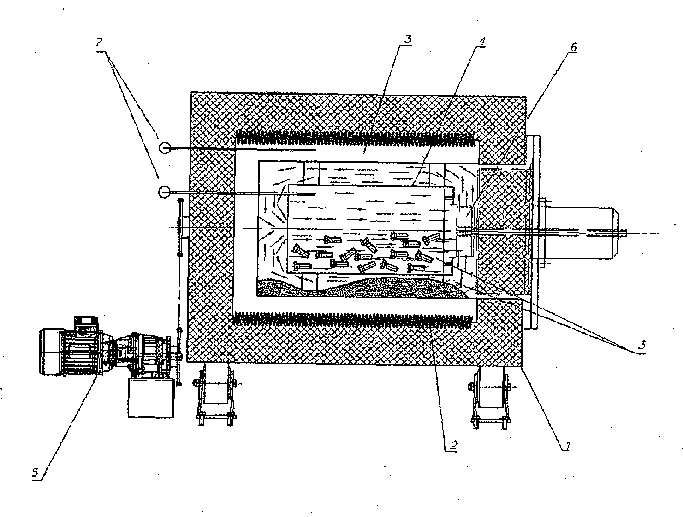

The unit being the subject of the invention, in an example, but not limiting, implementation was presented on the figure, where a cross-section of the unit in the vertical plane passing through the lengthwise axis of the smaller retort was shown

A solution according to the invention enables the elimination of flaws of the existing technology of thermal diffusion of zinc into the surface, improving the corrosion and friction protection properties of steel products. These products are most frequently products for which there are strength properties requirements. These properties are obtained through thermal treatment processes. Another treatment, which is the deposition of a zinc corrosion protection on the surface results in the decrease of the initial strength of the element due to process temperature. Electrolytic and spray zinc coating should not generate such problems, however corrosion resistance of such coatings is frequently insufficient. In case of zinc coating of bolts the most frequently used technique is dip coating. Due to difficulties in the preparation of the surface of such elements before zinc coating, during the process the zinc temperature is increased even up to 530°C in order to melt the fraction of impurities, which could not be removed earlier. This treatment is risky, due to the loss of the bolt material's strength properties in high temperature. The proposed thermal diffusion zinc coating technology according to the invention will be characterised by parameters which enable the obtaining of appropriate protective layers and maintaining strength properties of the products. At the same time, it will be possible to conduct a simultaneous process of saturating the surface with zinc and of tempering during the heat treatment process. The invention will be used in particular for high strength bolts, used for the fastening of zinc-coated structures. A second specific area of the implementation of the proposed technology according to the invention would be its use for corrosion protection and tribological protection of the elements used in the deep drilling process and during the exploration and production of petrochemical raw materials.
Currently products of chromium-nickel-molybdenum steels are used during exploration and production operations due to the aggressiveness of the environment, which results in high costs of materials. There is a significant demand for the use of less expensive, high strength materials, while the resistance of the product to the aggressive environment would be provided by the durable protective coating.
The proposed solution according to the invention of thermal diffusion zinc coating meets the aforementioned requirements for the properties of obtained coatings.
A unit according to the invention enables high efficiency and economic effectiveness of the entire technological process, and provides products with improved parameters of obtained protective coatings.

The most important innovative features of the solution according to the invention (qualitative and quantitative indicators):
□ thermal diffusion deposition of coatings of zinc, zinc-aluminium and with an admixture of other elements which improve the coating properties,
□ improvement of the corrosion protection properties of the coat by approx. 20-30% compared to the currently obtained thermal diffusion coatings,
□ improvement of abrasion resistance of the coats and decreasing their brittleness due to the structure of inter-metallic phases,
□ obtaining a hardness above 40 HRC,
□ lower costs of production of powder mixtures by the use of compounds obtained in other processes and considered to be waste,
□ shortening the process time by increasing the coating quality due to reaction atmosphere recirculation,
□ use of metallization process for steel high-strength elements without the risk of decreasing of material properties after the process,
□ possibility of obtaining a coat with a required thickness and structure.

Increase of product utility:
□ use in various fields of industry and various branches,
□ significant improvement of effectiveness and efficiency of the technological process,
□ possibility of conducting the technological process with one-sided coating of the products,
□ decreasing the consumption of raw materials and materials in the technological process,
□ significant reduction of waste in the technological process,

Usage possibilities:
□ market demand for high strength steel products, protected with an effective anti-corrosion coating with significant abrasion resistance,
□ demand for products with a coating obtained through a thermal diffusion process, with lower production costs,
□ looking for technological processes, which guarantee the reduction of waste and of imperfections in product properties,
□ obtaining on the zinc-coated elements of an excellent painting substrate by obtaining a surface with a high expansion area. This provides an excellent possibility of providing structures with high corrosion protection and durability requirements with a colour painted surface.

Increasing corrosion protection, while improving the plastic properties of the coating - decreasing the brittleness of the deposited coats. Decreasing of the powder mixture's production costs.

For this purpose the project anticipates the introduction of active ingredients into the zinc-based saturation mixture, in the form of aluminium, as well as the introduction of zinc in the form of a waste product obtained during dip galvanization process, that is "hard zinc", an iron-zinc compound. The use of ξ phase (FeZn13) containing approximately 6% of iron enables in justified cases to increase the mixture's operating temperature, which will have a positive impact on the coat growth kinetics, while simultaneously decreasing the costs of the mixture.
Introduction of zinc in the form of an intermetallic phase will impact the improvement of technological properties of the saturation mixture.
There is also a possibility of introducing supplementary additives in the form of chromium carbide and silicon carbide, which will be introduced into the powder mixture in order to improve the properties of protective coatings. The chromium carbide and silicon carbide is frequently used in surface treatment processes, and as a subgrain (waste product after the segregation process) may be used in the thermal diffusion coating deposition process.
The silicon from the silicon carbide modifies the properties of mixture with the contribution of aluminium, and the chromium carbide prevents the segregation of mixture components, in particular the addition of zinc.
The introduction of a reaction atmosphere recirculation system ensures its uniform composition, which will impact the intensification of the saturation process and the effectiveness of the use of active ingredients.
This system provides the possibility of introducing of inert atmosphere and its control during the duration of the process.
Introduction of an addition of aluminium into the mixture increases the corrosion resistance of the obtained coat. This additive, in addition to the improvement of corrosion protection properties of the coat reduces it's propensity for cracking

### Bibliography

### Patents

### Patenty

[1] Cowper-Coles S., *Process of depositing metals on metallic surfaces and the product thereof,* Patent
   No. 701,298, United States Patent Office, 1902.
[2] Schroeder A. F., *Sherardizing apparatus,* Patent No. 933,725, United States Patent Office, 1909.
[3] Collins E. F., Carp J. A., *Process of sherardizing,* Patent No. 1,169,529, United States Patent Office,
   1916.
[4] Harrison H. C., *Apparatus for sherardizing articles,* Patent No. 1,291,866, United States Patent
   Office, 1919.
[5] Kirk C. J., *Sherardizing Apparatus,* Patent No. 1,327,102, United States Patent Office, 1920.
[6] MacFarland A. M., *Sherardizing furnace,* Patent No. 1,433,735, United States Patent Office, 1922.
[7] Kirk C. J., *Apparatus for sherardizing metal articles,* Patent No. 1,552,059, United States Patent
   Office, 1925.
[8] Zimmerman L. C., *Apparatus used in the process of heat treating metallic articles,* Patent No.
   1,850,576, United States Patent Office, 1932.
[9] Shtikan I., Almen J., *Method for obtaining thermal diffusion coating,* Patent No. 7,192,624, United
   States Patent Office, 2007. Patent przydzielony firmie Distek Ltd.
[10] Shtikan I., Sheinkman A., *Powder mixture for thermal diffusion coatings,* Patent No. 6,171,359,
   United States Patent Office, 2001.
[11] Rosenthul I., *Corrosion resistant poly-metal diffusion coatings and method of applying same,*
   Patent No. 7,241,350, United States Patent Office, 2007. Patent przydzielony firmie Greenkote
[12] Graf W., Natrup F., Pohl M., *Sherardizing method,* Patent No. EP 2,271,784 B1, European Patent
   Office, 2009.
[13] Distek Ltd, *Metal based powder mixture for use in a thermal diffusion coating process, preparation*
   *method thereof and thermal diffusion coating process,* Application No. 112266, State of Israel
   Patent Office, 1995.
[14] Stewart O., McCulloch L., *Method of sherardizing,* Patent No. 1,513,349, United States Patent
   Office, 1924.
[15] Zhongquan Wu, Han Lijun, *Furnace body rotary powder zinc penetration equipment,* Patent no.
   CN 2474544Y, State Intellectual Property Office of P.R.C, 2006.
[16] 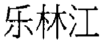 , Sherardizing furnace, Application No. CN 200910029030, State Intellectual Property
   Office of P.R.C, 2010.

### Literature

[17] Vourlias G., et al., Zinc edposition with pack cementation on low carbon steel substrates, Journal of Alloys and compounds, vol. 416, 2006.
[18] Vourlias G., et al., Zinc coatings for oxidation protection of ferrous substrates, Journal of Thermal Analysis and Calorimetry, vol. 90, 2007.
[19] Vourlias G., et al., A comparative study of the structure and the corrosion behaviour of zinc coatings deposited with various methods, Surface and Coatings Technology, vol. 200, 2006.
[20] Yedong H., et al., Corrosion resistance of Zn-Al co-cementation coatings on carbon steels, Material Letters, vol. 56, 2002.
[21] Balandin Y., et al., Zinc- and Aluminium-Based Protective Coatings Obtained in a Fluidized Bed, Protection of Metals, vol. 42, No. 4, 2006.
[22] Chaliampalias D., et al., The effect of Al and Cr additions on pack cementation zinc coatings, Applied Surface Science, vol. 256, 2010.
[23] Mechowicki K., *Cynkowanie termodyfuzyjne* - *trwale I ekologiczne zabezpieczenie antykorozyjne*
   *malych i średnich elementów,* Inzynieria powierzchni, nr 4, 2012.
[24] Lewiński Z., *Cynkowanie termodyfuzyjne,* Ochrona przed korozj 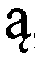 , nr 10, 2004.
[25] Chaliampalias D., et al., Deposition of zinc coatings with fluidized bed technique, Material Letters, vol. 61, 2007.
[26] Pistofidis N., et al., DSC study of the deposition reactions of zinc pack coatings up to 550°C, Journal of Thermal Analysis and Calorimetry, vol. 84, 2006.
[27] Vourlias G., et al., Mechanism and kinetics of the formation of zinc pack coatings, Journal of Thermal Analysis and Calorimetry, vol. 91, 2008.

## Claims

1. A method for depositing a layer of zinc on the surface of steel elements by keeping the elements in zinc powder, containing inert additives, advantageously zinc chloride or ammonium chloride as gas activators which generate the reaction atmosphere and heating over a time of (1-1.5) hours to a temperature of (370-490)°C, afterwards annealing in this temperature within a time of up to 4 hours, afterwards cooling together with the furnace to the ambient temperature, **characterized in that** the charge for the deposition of a zinc layer is placed in a central retort, and the zinc powder with inert additives and activator is placed in the main retort, whereas both retorts are placed basically on the same axis, moreover the zinc powder in the form of a powder mixture is heated to a temperature exceeding 330°C, in which the activator decomposes into ammonia, chlorine and hydrogen, and afterwards, as a result of the flow of active gases forced by a fan, generating zinc chloride through an internal retort it covers the surface of the poured over elements by the contact of the steel charge with zinc and zinc chloride in gas form.

2. A unit for the deposition of a zinc layer on the surface of steel elements, having a heating element for the heating and maintaining of the charge temperature, **characterized in** it being formed by a body, in which heating elements are placed and a chamber which forms the main retort for the pouring of the zinc powder and a smaller central retort, advantageously placed in the same axis with the main retort, used to contain the charge, whereas the central retort is placed on an axis connected with the drive mechanism, which causes an oscillatory movement around the lengthwise axis, and a fan for forcing the flow of the reaction atmosphere by the central retort, moreover the central retort cylinder has on both sides a perforated closure, ensuring the flow of reaction atmosphere and powder suspension.

3. A method according to claim 2 **characterized in that** the central retort moves in an oscillatory manner within the range of 330° compared to its lengthwise axis.
